# EUROPEAN PATENT SPECIFICATION

(11) **EP 1 486 552 B1**
(45) Date of publication and mention of the grant of the patent: **19.12.2007**
(21) Application number: 04013470.2
(22) Date of filing: 08.06.2004
(51) Int. Cl.: C09K 11/06, H05B 33/14, H01L 51/50, H01L 51/30, C07D 235/22

(54) **Organic electroluminescent material, organic electroluminescent device, and heterocycle-containing iridium complex compound**
Organisches elektrolumineszentes Material, organische elektrolumineszente Vorrichtung und heterozyklischer Iridium-Komplex
Matériau organique électroluminescent, dispositif organique électroluminescent et complexe d'iridium contenant des hétérocycles

(30) Priority: 12.06.2003 JP 2003167828
(43) Date of publication of application: 15.12.2004
(73) Proprietor: Sony Corporation, Tokyo 141 (JP)
(72) Inventor: Takada, Ichinori, Shinagawa-ku, Tokyo (JP); Ishibashi, Tadashi, Shinagawa-ku, Tokyo (JP); Yamada, Jiro, Shinagawa-ku, Tokyo (JP); Tamura, Shinichiro, Shinagawa-ku, Tokyo (JP)
(74) Representative: Rupp, Christian

(56) References cited:
- WO-A-01/41512
- WO-A1-20/04045002
- US-A1- 2001 019 782
- US-A1- 2002 094 453
- US-A1- 2002 100 906

## Description

### BACKGROUND OF THE INVENTION

### 1. Field of the Invention

The present invention relates to an organic electroluminescent material, an organic electroluminescent device, and a heterocycle-containing iridium complex compound having light emission properties in the region from green to blue, which is advantageously used as an organic electroluminescent material.

### 2. Related Art

An organic electroluminescent (organic EL) display has advantages in that the colors are clear and the panel can be manufactured so as to have reduced thickness, and has as a consequence received attention as a candidate for the next-generation flat panel display. However, in order to bring it into practical use, there are inevitable issues of improving materials to increase the light emission efficiency and prolonging the lifetime of light emission. In recent years, in order to solve the problem, the development of phosphorescent materials has been vigorously conducted, but materials emitting light in the region from green to blue are still in a developing stage.

Generally, in the excitation of a light-emitting material, a process in which the material is deactivated after emitting a fluorescent light and a process in which the material undergoes intersystem crossing and then is deactivated as a phosphor are known, and it is considered that a high theoretical efficiency can be obtained in the latter process. Recently, it has been reported that a complex of a transition metal (especially iridium) has large intersystem crossing and can exhibit high EL emission efficiency, and this report has drawn attention. For example, refer to Thompson et al.: J. Am. Chem. Soc. 2001, 123, 4305.

WO 2004/045002 A1 describes organic light emitting materials and devices including said materials. Particularly preferred embodiments of the light emitting materials are shown in formulae 2 and 3. The compounds therein disclosed can have included iridium as a preferred metal and a preferred ancillary ligand may be acetylacetonate. The imidazol derivative may be condensed or substituted with an aryl. In addition, one of the nitrogen atoms (which is not involved in complexation) may be substituted.

However, in the development of a material which emits light in the region from green to blue, studies must be made on ligand. An attempt to substitute a ligand with an electron attractive substituent, such as a fluorine atom, is currently being made, for example, according to Thompson et al. : ICEL. 2001, p.45 , but it is important to combine an electron-donating substituent and an electron attractive substituent to balance the electron attractive property with the electron-donating property.

### SUMMARY OF THE INVENTION

The present invention has been conceived in view of the above-mentioned problems in the related art, and it is aimed to provide a novel iridium complex compound which emits light in the region from green to blue, and to provide an organic EL device using the iridium complex compound providing higher efficiency and extended lifespan.

The inventors of the present invention have conducted intensive studies with a view toward developing a iridium complex material having phosphorescence in the region from green to blue. As a result, they have found that, by introducing a plurality of nitrogen atoms into the heterocycle in the molecule of a ligand and substituting the two benzene rings in the ligand with an electron attractive substituent and an electron-donating substituent to control the electronic state of the ligand, a novel heterocycle-containing iridium complex compound having excellent light emission properties can be obtained.

Further, by forming an organic layer containing a light emission region using an organic electroluminescent material comprising the heterocycle-containing iridium complex compound according to a preferred embodiment of the present invention, there can be provided an EL device which emits light in the region from green to blue with high efficiency and extended lifespan.

### BRIEF DESCRIPTION OF THE DRAWINGS

The above and other objects and features of a preferred embodiment of the present invention will become more readily apparent to those of ordinary skill in the art from the following detailed description taken in conjunction with the accompanying drawings in which:
FIG. 1 shows a diagrammatic cross-sectional view of one example of the structure of a bottom emission type organic EL device according to a preferred embodiment of the present invention.
FIG. 2 shows diagrammatic cross-sectional view showing one example of the structure of a top emission type organic EL device according to a preferred embodiment of the present invention.
FIG. 3 shows a diagrammatic cross-sectional view showing the basic structure of a top emission type organic EL device according to a preferred embodiment of the present invention.

### DETAILED DESCRIPTION OF THE PREFERRED EMBODIMENTS OF THE PRESENT INVENTION

The preferred heterocycle-containing iridium complex compound is represented by any one of the following structural formulae (2-1) to (2-4). 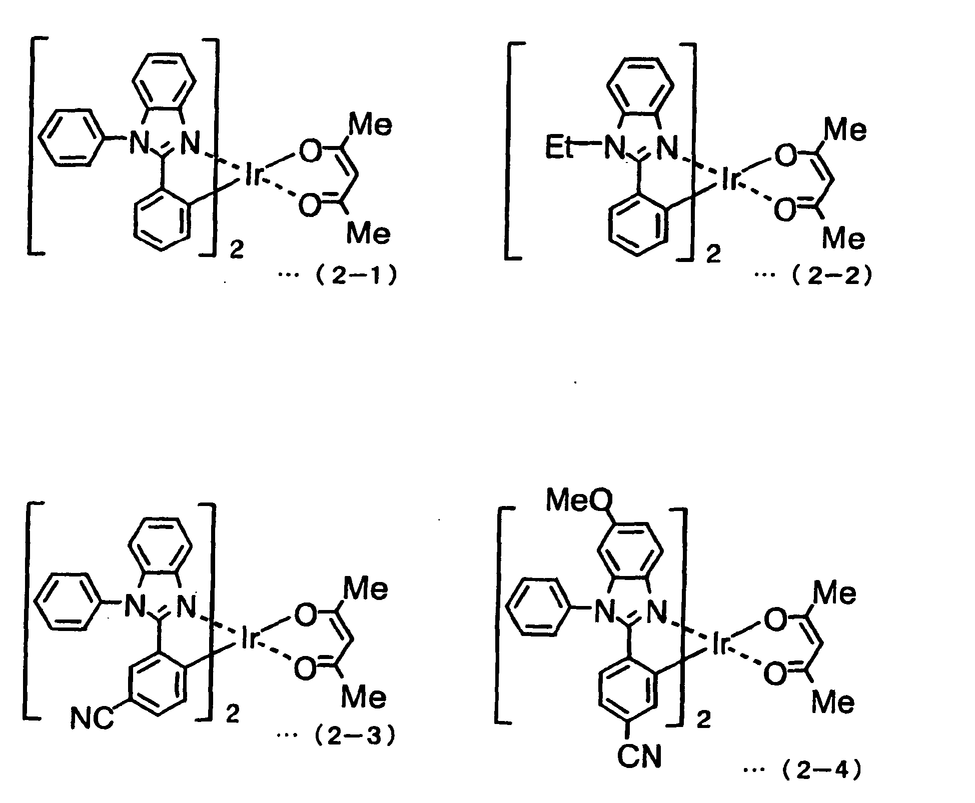 hexachloroiridate and 2-methoxyethanol (Nonoyama's method (Bull. Chem. Soc. Jpn. 1794, 47, 767.)), and then heated in 2-ethoxyethanol, together with 1,4-pentanedione and sodium carbonate, followed by purification (Lamansky et al. method (Inorg. Chem. 2001, 40, 1704.)).

A novel heterocycle-containing iridium complex compound according to the present invention can be advantageously used as an organic electroluminescent material which emits light in the region from green to blue, and, using an organic electroluminescent material comprising the iridium complex compound, an organic electroluminescent device having high light emission efficiency and extended lifespan can be provided.

The heterocycle-containing iridium complex compound according to the present invention can be used not only as a material for the above-mentioned organic electroluminescent device but also in medical applications, a fluorescent brightener, a material for photography, a UV absorbing material, a laser dye, a dye for color filter, and a color conversion filter.

Next, an organic electroluminescent device according to a preferred embodiment of the present invention will be described with reference to the drawing.

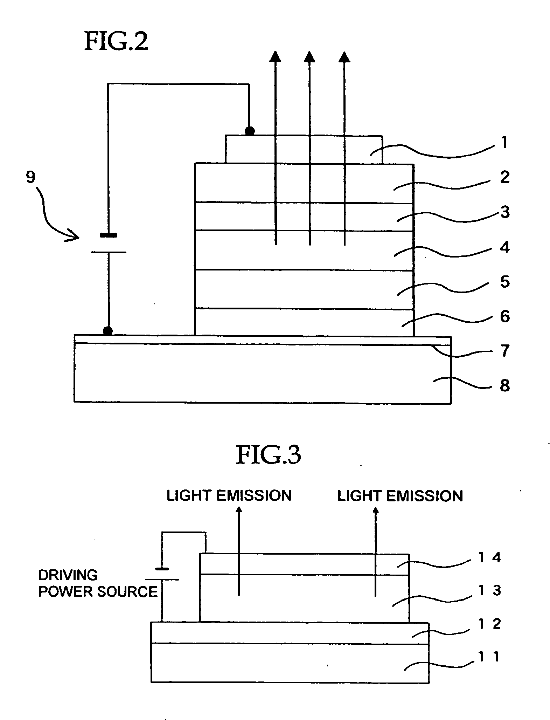

FIG. 3 shows a diagrammatic cross-sectional view of an example of the organic electroluminescent device according to a preferred embodiment of the present invention. This organic electroluminescent device comprises an anode 12, an organic layer 13 containing a light emission region, and a cathode 14 formed in this order on a substrate 11. This organic electroluminescent device is a top emission type organic electroluminescent device which emits light from the cathode side.

The organic electroluminescent device may have, between the electrodes, an organic layer, such as a light emitting layer, a hole injection layer, a hole transport layer, a hole blocking layer, or an electron transport layer, and a protecting layer and, by appropriately selecting the material, a layer other than the light emitting layer in these layers or the interface between the layers may emit light.

In the substrate 11, glass, a plastic, or another appropriate material can be used, but preferred is glass which most advantageously suppresses penetration of moisture from the outside. When the organic electroluminescent device and another display device are used in combination, the substrate 11 can be common to them. In the anode 12, a stacked structure comprising a highly reflective metal material, such as chromium (Cr), or an ITO layer and an Ag alloy can be used.

The organic layer 13 contains an organic electroluminescent material comprising the heterocycle-containing iridium complex compound represented by the structural formulae (2-1) to (2-4) above.

The heterocycle-containing iridium complex compound according to the present invention as an organic electroluminescent material has properties such that it emits blue light with high efficiency, and therefore, when the compound is contained in the light emitting layer in the organic layer, the electroluminescent device can be improved in light emission efficiency. In addition, the heterocycle-containing iridium complex compound has excellent charge transportability, and therefore, when the compound is contained in the charge transport layer, the electroluminescent device can be improved in light emission efficiency. Therefore, there can be provided an electroluminescent device which is advantageous not only in that it can reduce energy consumption during the light emission, but also in that it can continue blue light emission with high luminance for a long time.

In the electroluminescent device as mentioned above, it is preferred that a layer containing a compound having an ionization potential of 5.9 eV or higher, more advantageously 6.0 to 7.0 eV, is disposed between the cathode and the light emitting layer, and it is more preferred that an electron transport layer having an ionization potential of 5.9 eV or higher is disposed. Appropriate materials can be used in the individual layers. In such electroluminescent device, the heterocycle-containing iridium complex compound can be contained not only in the light emitting layer in the organic layer as a light emitting material, but also in the charge transport layer in the organic layer.

With respect to the method for forming a layer containing the heterocycle-containing iridium complex compound, there is no particular limitation, and various methods, such as a vacuum deposition method, an LB method, a resistive heating deposition method, an electron beam method, a sputtering method, a molecule stacking method, a coating method (e. g., a spin coating method, a casting method, or a dip coating method), an ink-jet method, and a printing method, can be employed, and, from the viewpoint of obtaining excellent properties and facilitating the preparation, a resistive heating deposition method is preferred.

As an electrode material for the cathode 14, an alloy of an active metal, such as Li, Mg, or Ca, and a metal, such as Ag, Al, or In, or a stacked structure comprising these metals can be used. In the organic electroluminescent device, the thickness of the cathode is controlled to obtain a thickness such that the device transmits light emitted from the cathode side.

In the above embodiment, an explanation is made on the so-called top emission type organic electroluminescent device which emits light from the cathode side on top, but the organic electroluminescent device according to a preferred embodiment of the present invention is not limited to this type and can also be applied to a so-called bottom emission type organic electroluminescent device which emits light from the anode side on bottom. The bottom emission type organic electroluminescent device comprises, for example, a light transmitting anode comprised of ITO formed on a glass substrate, a light emitting layer formed on the anode, and a light reflecting cathode formed on the light emitting layer. The organic electroluminescent device can be applied to a transmission type organic electroluminescent device comprising an anode and a cathode both of which are comprised of a light transmitting material, such as ITO.

The organic electroluminescent device according to the present invention can be used in applications in a wide variety of fields, such as display device, display, backlight, electrophotography, illuminating light source, recording light source, exposure light source, reading light source, sign, advertising board, interior, and optical communication.

### Examples of preferred embodiments of the invention

Next, preferred examples of embodiments of the present invention are shown, but such examples should not be construed as limiting the scope of the present invention.

### Example 1

A heterocycle-containing iridium complex compound represented by the structural formula (2-1) above was synthesized in accordance with the following reaction formula.

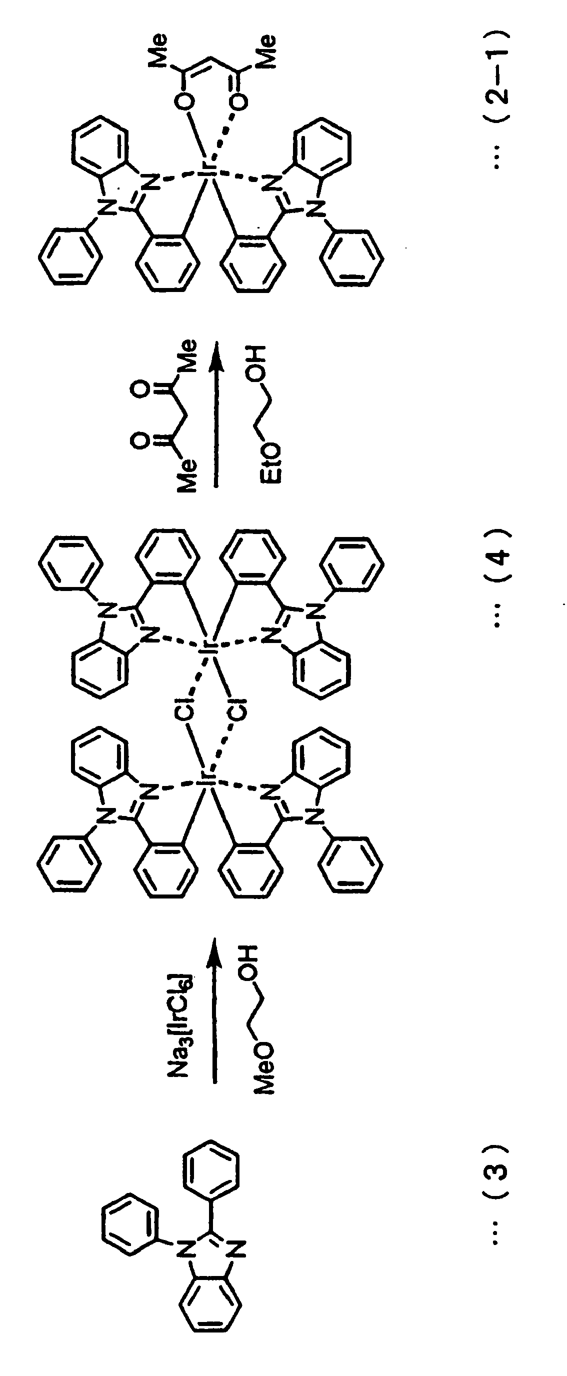

The compound represented by the structural formula 4 in the above reaction formula was synthesized from the compound represented by the structural formula 3 in the same reaction formula in accordance with the Nonoyama's method (Bull. Chem. Soc. Jpn. 1794, 47, 767.). The heterocycle-containing iridium complex compound represented by the structural formula (2-1) above was synthesized from the compound of the structural formula 4 above in accordance with the method of Lamansky et al. (Inorg. Chem. 2001, 40, 1704.).

Specifically, the compound of the structural formula 3 (2.7 g, 9.9 mmol) and sodium hexachloroiridate (1.6 g, 3.3 mmol) were stirred in 2-methoxyethanol for 24 hours. The resultant precipitate (compound of the structural formula 4) was washed with ethanol again, and then heated under reflux in 2-ethoxyethanol for 15 hours, together with 1,4-pentanedione (6.7 g, 66 mmol) and sodium carbonate (1.4 g, 13 mmol). The resultant insoluble substance was collected by filtration, and washed with water, ethanol, ether, and hexane. The residue was purified by silica gel chromatography (developing solvent: methylene chloride), and permitted to undergo sublimation to obtain the compound of the structural formula (2-1) (410 mg; yield based on sodium hexachloroiridate: 15%).

Data for identification of the compound of the structural formula (2-1) above are as follows.
(1) ¹H NMR (CD₂Cl₂/ppm) ; δ 1.9 (s, 6H), 5.3 (s, 1H), 6.4 - 6.6 (8H), 7.1 - 7.2 (2H), 7.2 - 7.3 (4H), 7.6 - 7.7 (10H), 7.7 - 7.8 (2H)
(2) MS (FAB) [M]⁺: 829
(3) Abs (CH₂Cl₂) 410 nm
(4) PL (CH₂Cl₂) 520 nm

### Example 2

A heterocycle-containing iridium complex compound represented by the structural formula (2-2) above was synthesized in accordance with substantially the same procedure as in Example 1 except that, instead of the compound of the structural formula 3 in Example 1, a compound of the structural formula below was used. As a result, the yield (based on sodium hexachloroiridate) of the iridium complex compound was found to be 12%.

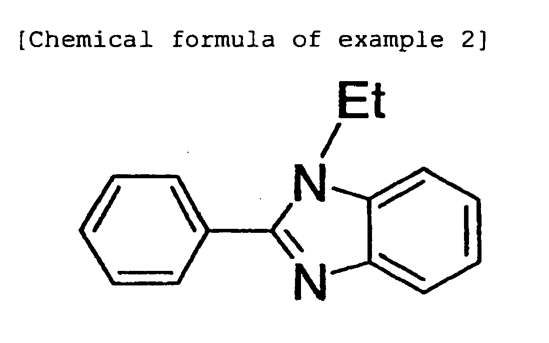

Data for identification of the above iridium complex compound are as follows.
(1) ¹H NMR (CD₂Cl₂/ppm); δ 1.3 (t, 6H), 1.9 (s, 6H), 2.3 (q, 4H), 5.2 (s, 1H), 6.4-6.5 (4H), 7.1-7.2 (2H), 7.3 - 7.6 (8H), 7.7 - 7.8 (2H)
(2) MS (FAB) [M]⁺: 733
(3) Abs (CH₂Cl₂) 410 nm
(4) PL (CH₂Cl₂) 520 nm

### Example 3

A heterocycle-containing iridium complex compound represented by the structural formula (2-3) above was synthesized in accordance with substantially the same procedure as in Example 1 except that, instead of the compound of the structural formula 3 in Example 1, a compound of the structural formula below was used (CAS No. 175712-80-8). As a result, the yield (based on sodium hexachloroiridate) of the iridium complex compound was found to be 15%.

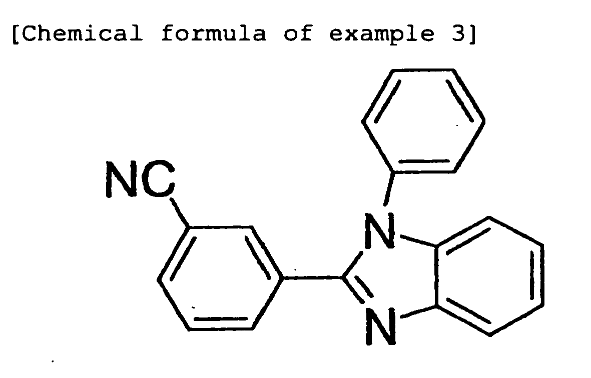

Data for identification of the above iridium complex compound are as follows.
(1) ¹H NMR (CD₂Cl₂/ppm) ; δ 1.8 (s, 6H), 5.3 (s, 1H), 6.4 - 7.2 (8H), 7.2 - 7.3 (4H), 7.5 - 7.6 (10H), 7.7 - 8.0 (4H)
(2) MS (FAB) [M]⁺: 879
(3) Abs (CH₂Cl₂) 410 nm
(4) PL (CH₂Cl₂) 500 nm

### Example 4

A compound represented by the structural formula 6 below was synthesized from a compound represented by the structural formula 5 below in accordance with the following reaction formula.

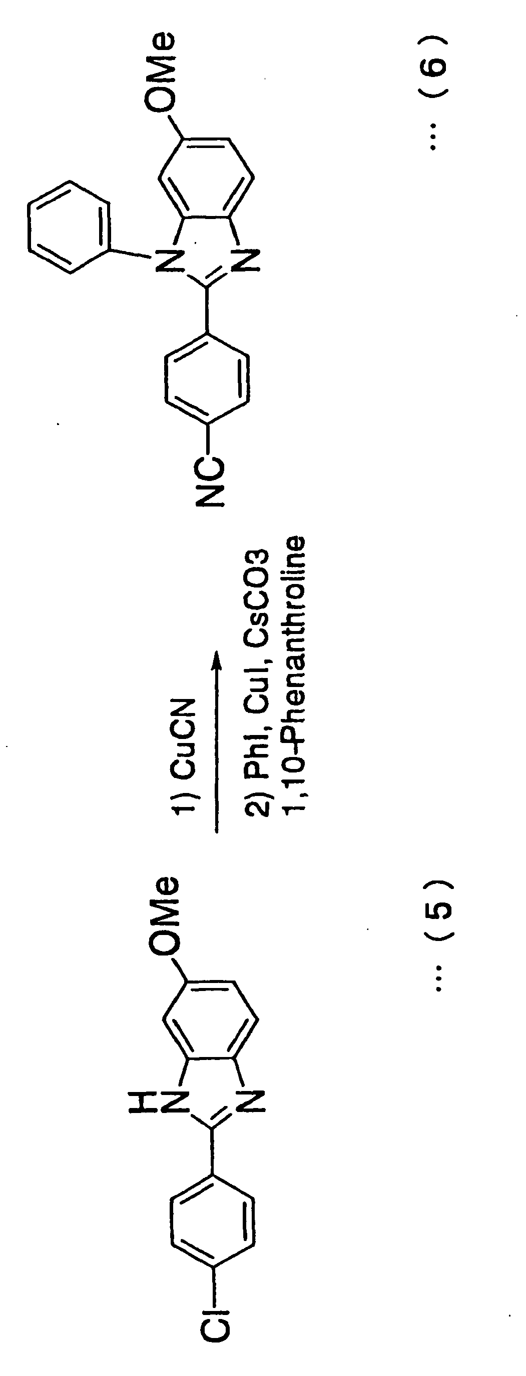

Specifically, the compound of the structural formula 5 above (synthesized in accordance with Eur. J. Med. Chem. 1996, 31, 635.)(5.0 g, 19 mmol) and copper(I) cyanide (8.7 g, 98 mmol) were heated under reflux in 500 ml of dioxane for 12 hours. The reaction solution was concentrated, washed with water, and dried, and to the resultant solid were added iodobenzene (3.9 g, 19 mmol), cesium carbonate (19 g, 58 mmol), copper(I) iodide (370 mg, 1.9 mmol), 1,10-phenanthroline (700 mg, 3. 9 mmol), and 200 ml of dioxane, followed by heating under reflux for 36 hours. The resultant reaction mixture was concentrated, and purified by silica gel chromatography (developing solvent: hexane-chloroform-toluene) to obtain 1.5 g of the compound represented by the structural formula 6 above. Complete purification was difficult, and therefore clear spectral data was not obtained, but, in the measurement of MS spectrum, a molecular ion peak ([M]⁺: 326) was observed.

Then, using the compound represented by the structural formula 6, a heterocycle-containing iridium complex compound represented by the structural formula (2-4) above was synthesized. The procedure for the synthesis of this compound is the same as that for the heterocycle-containing iridium complex compound represented by the structural formula (2-1) above.

Data for identification of the above heterocycle-containing iridium complex compound are as follows.
(1) ¹H NMR (CD₂Cl₂/ppm) ; δ 1.8 (s, 6H), 3.5 (s, 6H), 5.3 (s, 1H), 6.4 - 7.2 (6H), 7.2 - 7.3 (4H), 7.6 - 7.7 (10H), 7.7-8.0 (4H)
(2) MS (FAB) [M]⁺: 889
(3) Abs (CH₂Cl₂) 400 nm
(4) PL (CH₂Cl₂) 480 nm

### Example 5

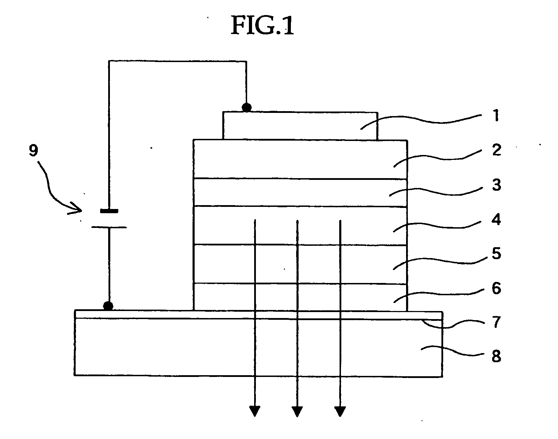

The present example is an example in which an organic electroluminescent device was prepared using the heterocycle-containing iridium complex compound represented by the structural formula (2-1) above prepared in Example 1 as a light emitting material. The structure of this electroluminescent device is diagrammatically shown in FIG. 1, and the reference numerals are as follows: 1: cathode; 2: electron transport layer; 3: hole blocking layer; 4: light emitting layer; 5: hole transport layer; 6: hole injection layer; 7: anode; 8: substrate; and 9: power source.

First, a 30 mm x 30 mm glass substrate having formed on one surface an anode comprised of ITO having a thickness of 100 nm was set in a vacuum deposition machine. As a deposition mask, a metal mask having a plurality of 2.0 mm x 2.0 mm unit apertures was disposed near the substrate, and CuPc (copper phthalocyanine) was deposited as a hole injection layer by a vacuum deposition method in a vacuum at 10⁻⁴ Pa or less so that the thickness of the resultant layer became 10 nm. The deposition rate was 0.1 nm/second.

Then, α-NPD represented by the structural formula below was deposited as a hole transport layer material directly on the hole injection layer. The thickness of the hole transport layer comprised of α-NPD was 30 nm, and the deposition rate was 0.1 nm/second.

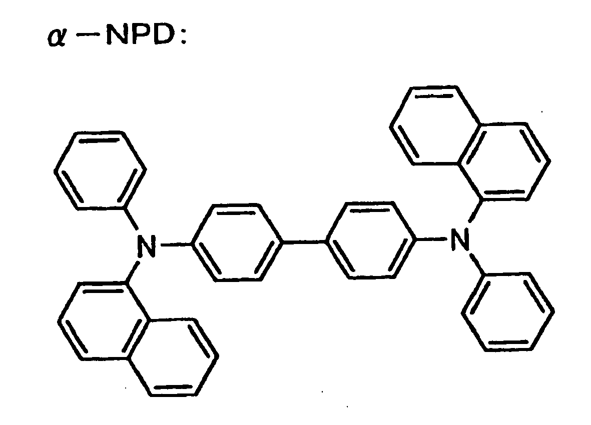

Subsequently, a light emitting layer comprised of the iridium complex represented by the structural formula (2-1) above and CBP (carbazolebiphenyl), which were mixed in a 94:6 weight ratio, was deposited directly on the hole transport layer. The thickness of the light emitting layer was 40 nm.

Then, BCP (bathocuproine) was deposited as a hole blocking layer material directly on the light emitting layer. The thickness of the hole blocking layer comprised of BCP was 10 nm, and the deposition rate was 0.1 nm/second.

Alq₃ {tris(8-hydroxyquinolinato)aluminum} represented by the structural formula below was deposited as an electron transport layer material directly on the hole blocking layer. The thickness of the electron transport layer comprised of Alq₃ was 30 nm, and the deposition rate was 0.2 nm/second.

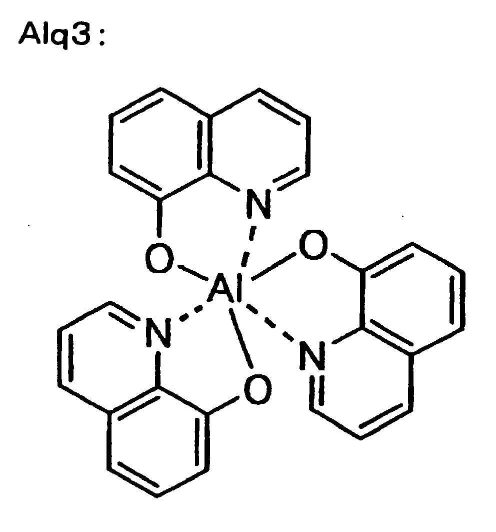

As materials for the cathode, a Mg and Ag co-deposited film was used and deposited at a deposition rate of 1 nm/second so that the thickness of the resultant film became 200 nm, thus preparing an organic electroluminescent device having the stacked structure shown in FIG. 1.

A forward bias direct voltage was applied to the thus prepared organic electroluminescent device in Example 5 in a nitrogen gas atmosphere to evaluate the light emission properties. The light emitted was green, and a spectrophotometry measurement offered a spectrum having an emission peak around 505 nm. In the spectrophotometry measurement, a spectrophotometer using a photodiode array, manufactured and sold by Otsuka Electronics Co., Ltd., as a detector was used. In addition, a voltage-luminance measurement was carried out, and, as a result, a luminance of 800 cd/m² was obtained at 8 V.

The organic electroluminescent device prepared was allowed to stand in a nitrogen gas atmosphere for one month, but no deterioration was observed in the device. Further, a fixed current was permitted to flow through the organic electroluminescent device at an initial luminance of 500 cd/m² so that the device continuously emitted light and suffered forced deterioration. As a result, it was found that a 900-hour period of time was required until the luminance reduced by half. The results are summarized in the Table 1 below.

### Example 6

The present Example is an example in which a top emission type organic electroluminescent device was prepared using the iridium complex compound represented by the structural formula (2-1) above as a light emitting material. The structure of this electroluminescent device is diagrammatically shown in FIG. 2, and like parts or portions are indicated by like reference numerals in FIG. 1 and FIG. 2.

As a substrate, using a 30 mm x 30 mm glass substrate having formed on one surface an anode comprised of Cr having a thickness of 100 nm, an organic electroluminescent device having the stacked structure shown in FIG. 2 was prepared. The other procedure for preparing the device and the materials are substantially the same as those in Example 1, except for the device structure. As a constituent material for the cathode 1, a Mg/Ag co-deposited film was used. The thickness of the co-deposited film was 11 nm.

A forward bias direct voltage was applied to the thus prepared organic electroluminescent device in Example 6 in a nitrogen gas atmosphere to evaluate the light emission properties. The light emitted was bluish green, and a spectrophotometry measurement offered a spectrum having an emission peak around 505 nm. In the spectrophotometry measurement, a spectrophotometer using a photodiode array, manufactured and sold by Otsuka Electronics Co., Ltd., as a detector was used. In addition, a voltage-luminance measurement was carried out, and, as a result, a luminance of 570 cd/m² was obtained at 8 V.

The organic electroluminescent device prepared was allowed to stand in a nitrogen gas atmosphere for one month, but no deterioration was observed in the device. Further, a fixed current was permitted to flow through the organic electroluminescent device at an initial luminance of 500 cd/m² so that the device continuously emitted light and suffered forced deterioration. As a result, it was found that a 780-hour period of time was required until the luminance reduced by half. The results are summarized in the Table 1 below.

### Example 7

The present Example is an example in which an organic electroluminescent device having the structure shown in FIG. 1 was prepared using the iridium complex compound represented by the structural formula (2-2) above as a light emitting material. The procedure for preparing the device, the device structure, and the materials are substantially the same as those in Example 5, except for the light emitting material. The results are summarized in the Table 1 below.

### Example 8

The present Example is an example in which an organic electroluminescent device having the structure shown in FIG. 2 was prepared using the iridium complex compound represented by the structural formula (2-2) above as a light emitting material. The procedure for preparing the device, the device structure, and the materials are substantially the same as those in Example 6, except for the light emitting material. The results are summarized in the Table 1 below.

### Example 9

The present Example is an example in which an organic electroluminescent device having the structure shown in FIG. 1 was prepared using the iridium complex compound represented by the structural formula (2-3) above as a light emitting material. The procedure for preparing the device, the device structure, and the materials are substantially the same as those in Example 5, except for the light emitting material. The results are summarized in the Table 1 below.

### Example 10

The present Example is an example in which an organic electroluminescent device having the structure shown in FIG. 2 was prepared using the iridium complex compound represented by the structural formula (2-3) above as a light emitting material. The procedure for preparing the device, the device structure, and the materials are substantially the same as those in Example 6, except for the light emitting material. The results are summarized in the Table 1 below.

### Example 11

The present Example is an example in which an organic electroluminescent device having the structure shown in FIG. 1 was prepared using the iridium complex compound represented by the structural formula (2-4) above as a light emitting material. The procedure for preparing the device, the device structure, and the materials are substantially the same as those in Example 5, except for the light emitting material. The results are summarized in the Table 1 below.

### Example 12

The present Example is an example in which an organic electroluminescent device having the structure shown in FIG. 2 was prepared using the iridium complex compound represented by the structural formula (2-4) above as a light emitting material. The procedure for preparing the device, the device structure, and the materials are substantially the same as those in Example 6, except for the light emitting material. The results are summarized in the Table 1 below.

**[Table 1]**

| Example | Compound | Device structure | Color of emitted light | Voltage-luminance property | Lifespan |
|---|---|---|---|---|---|
| 1 | Structural formula (2-1) | FIG. 1 | 505 nm (Green) | 800 cd/m² (8 V) | 900 hr (500 cd/m²) |
| 2 | | FIG. 2 | 505 nm (Green) | 570 cd/m² (8 V) | 780 hr (500 cd/m²) |
| 3 | Structural formula (2-2) | FIG. 1 | 505 nm (Green) | 780 cd/m² (8 V) | 910 hr (500 cd/m²) |
| 4 | | FIG. 2 | 505 nm (Green) | 580 cd/m² (8 V) | 800 hr (500 cd/m²) |
| 5 | Structural formula (2-3) | FIG. 1 | 500 nm (Green) | 850 cd/m² (8 V) | 830 hr (500 cd/m²) |
| 6 | | FIG. 2 | 500 nm (Green) | 595 cd/m² (8 V) | 710 hr (500 cd/m²) |
| 7 | Structural formula (2-4) | FIG. 1 | 480 nm (Green) | 900 cd/m² (8 V) | 600 hr (500 cd/m²) |
| 8 | | FIG. 2 | 480 nm (Green) | 610 cd/m² (8 V) | 540 hr (500 cd/m²) |

## Claims

1. An organic electroluminescent material comprising a heterocycle-containing iridium complex compound represented by the following structural formulae (2-1) to (2-4):

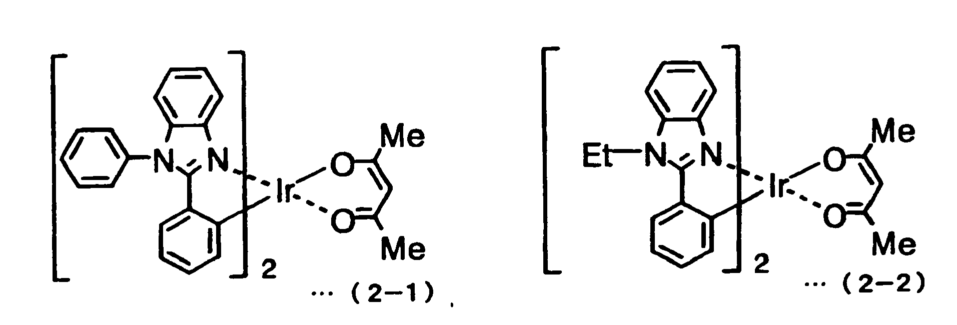

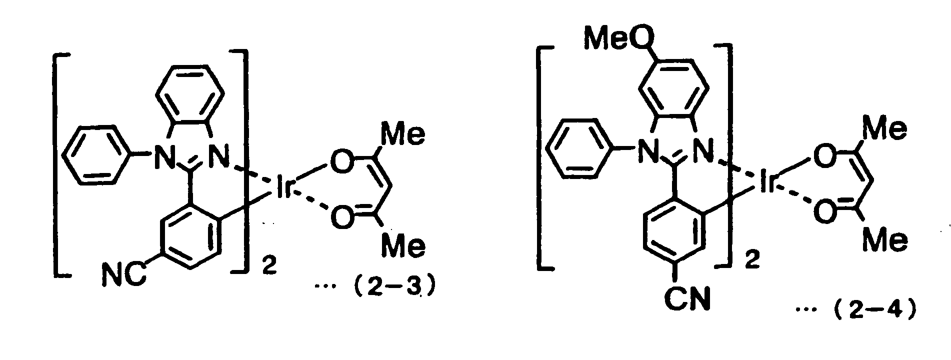

2. An organic electroluminescent device provided with an organic layer having a plurality of layers and having between a pair of electrodes at least a light emission region, said organic electroluminescent device having at least a layer of said organic layer including at least one heterocycle-containing iridium complex compound represented by the following structural formulae (2-1) to (2-4):

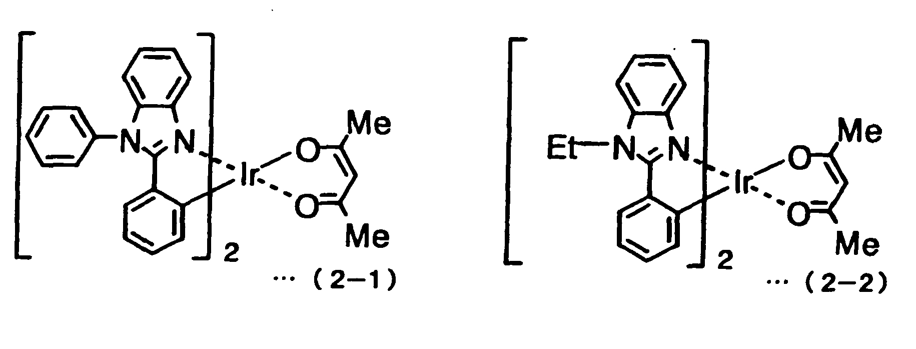

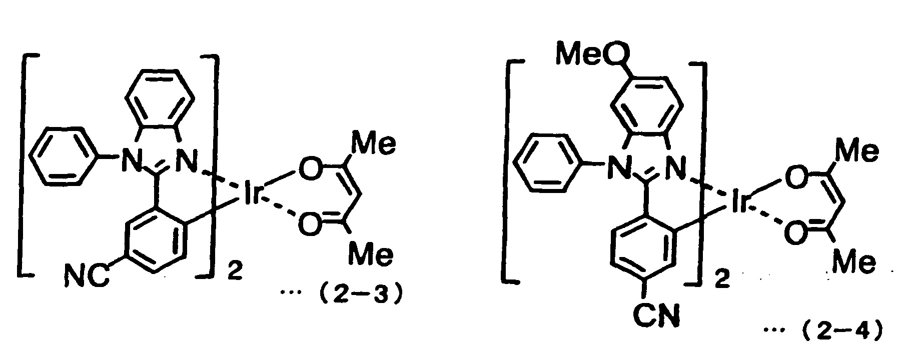

3. A heterocycloe containing iridium complex compound represented by the following structural formulae (2-1) to (2-4):

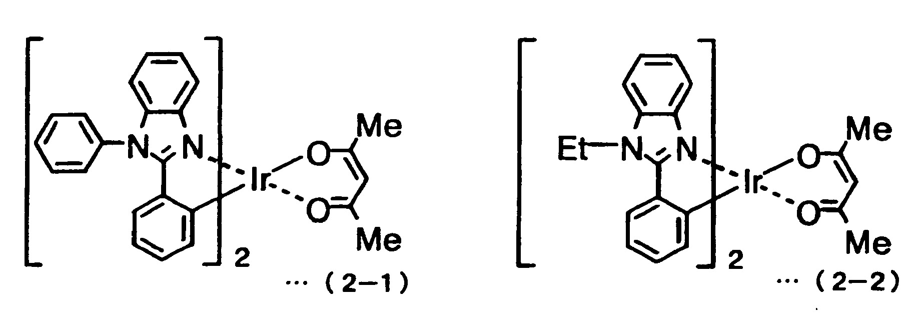

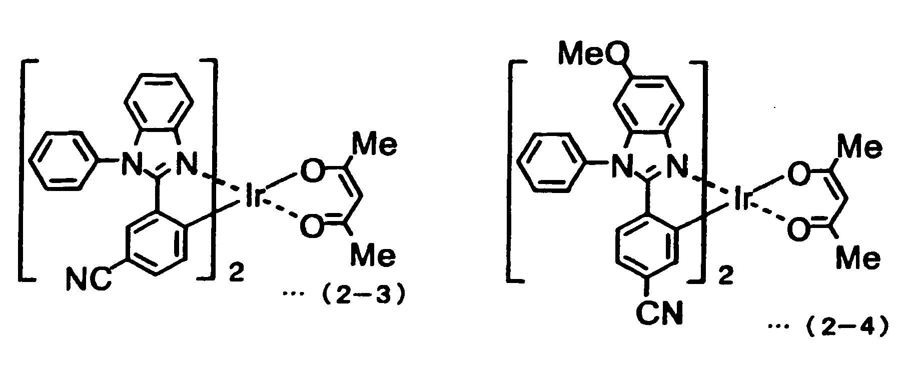

## Patentansprüche

1. Organisches elektrolumineszentes Material umfassend eine Iridium-Komplex-Verbindung mit einem Heterozyklus, die durch die folgenden Strukturformeln (2-1) bis (2-4) repräsentiert wird:

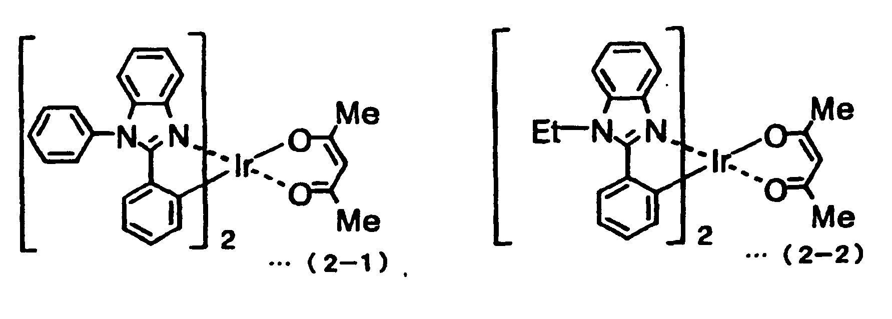

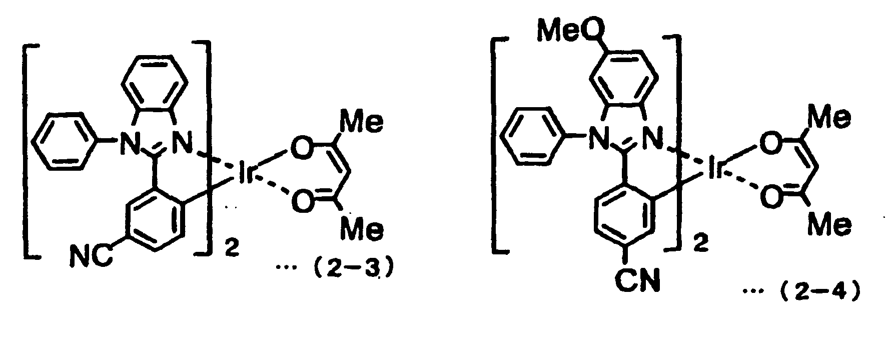

2. Organische elektrolumineszente Vorrichtung, die mit einer organischen Schicht ausgestattet ist, die eine Vielzahl von Schichten aufweist und die zwischen einem Elektrodenpaar zumindest einen Lichtemissionsbereich aufweist, wobei die organische elektrolumineszente Vorrichtung zumindest eine Schicht der organischen Schicht hat, die zumindest eine Iridium-Komplex-Verbindung mit einem Heterozyklus einschließt, die durch die folgenden Strukturformeln (2-1) bis (2-4) repräsentiert wird:

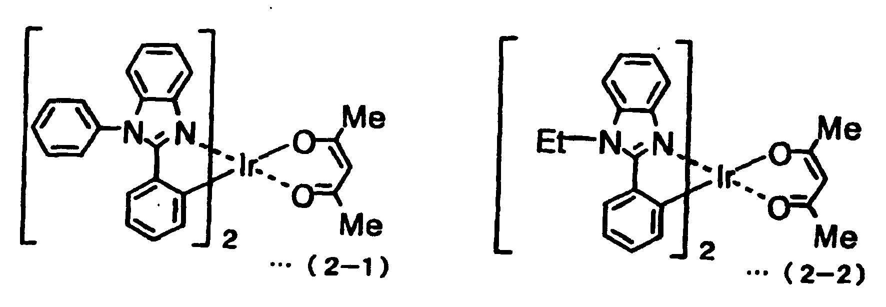

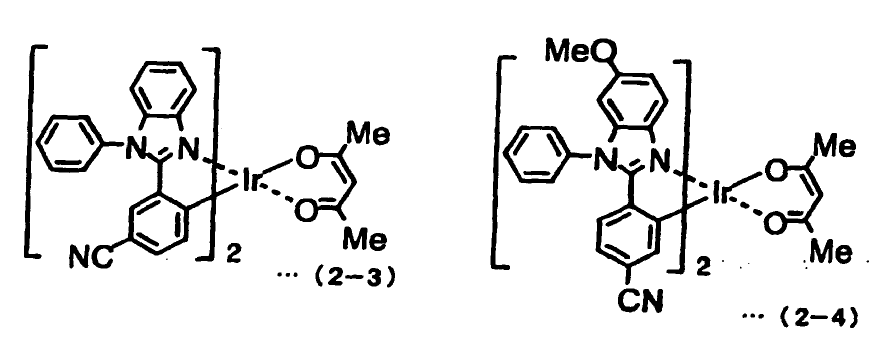

3. Iridium-Komplex-Verbindung mit einem Heterozyklus, die durch die folgenden Strukturformeln (2-1) bis (2-4) repräsentiert wird:

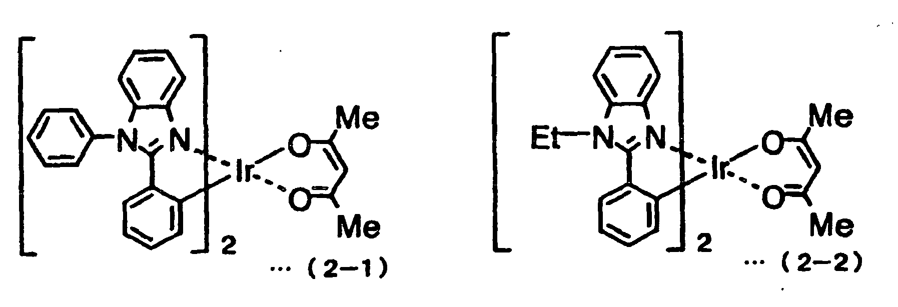

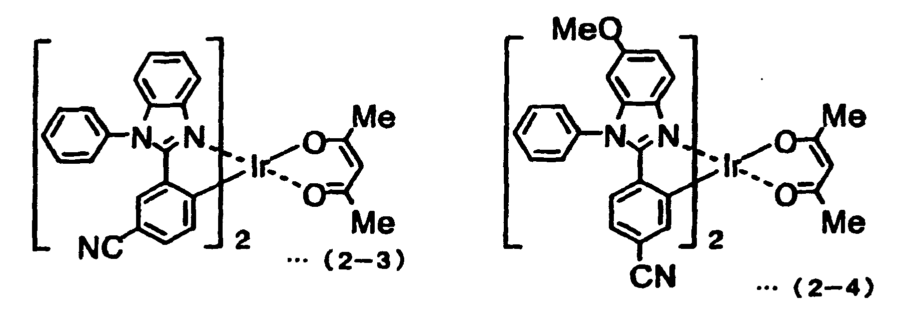

## Revendications

1. Matériau électroluminescent organique comprenant un composé de complexe d'iridium contenant un hétérocycle représenté par les formules structurelles (2-1) à (2-4) suivantes :

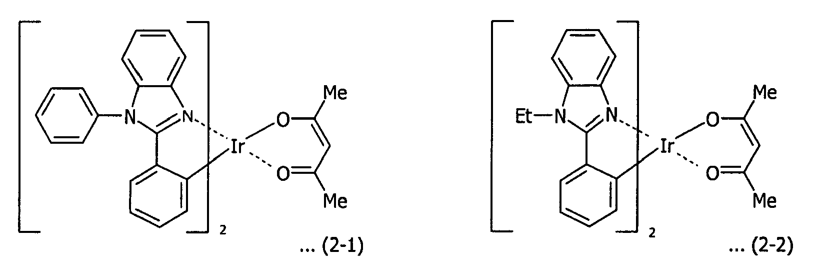

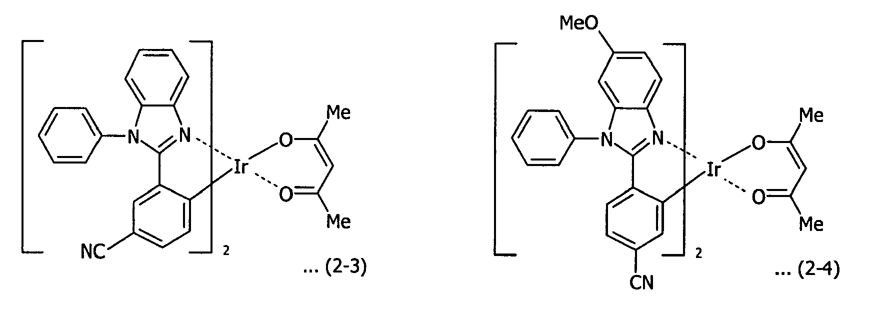

2. Dispositif électroluminescent organique muni d'une couche organique présentant de nombreuses couches et présentant entre une paire d'électrodes au moins une région d'émission de lumière, ledit dispositif électroluminescent organique présentant au moins une couche de ladite couche organique comprenant au moins un composé de complexe d'iridium contenant un hétérocycle représenté par les formules structurelles (2-1) à (2-4) suivantes :

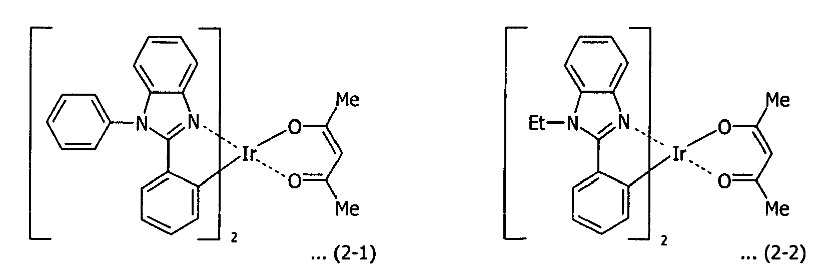

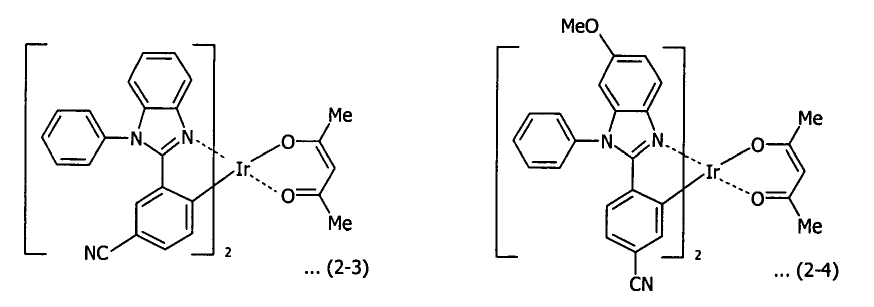

3. Composé de complexe d'iridium contenant un hétérocycle représenté par les formules structurelles (2-1) à (2-4) suivantes :
